# EUROPEAN PATENT APPLICATION

(11) **EP 2 639 820 A1**
(43) Date of publication of application: **18.09.2013**
(21) Application number: 10859611.5
(22) Date of filing: 10.11.2010
(51) Int. Cl.: H01L 21/338, H01L 29/778, H01L 29/812

(54) **SEMICONDUCTOR DEVICE, AND METHOD FOR PRODUCING SEMICONDUCTOR DEVICE**

(71) Applicant: Mitsubishi Electric Corporation, Tokyo 100-8310 (JP)
(72) Inventor: OISHI, Toshiyuki, Tokyo 100-8310 (JP); OTSUKA, Hiroshi, Tokyo 100-8310 (JP); YAMANAKA, Koji, Tokyo 100-8310 (JP); YAMAUCHI, Kazuhisa, Tokyo 100-8310 (JP); HANGAI, Masatake, Tokyo 100-8310 (JP); NAKAYAMA, Masatoshi, Tokyo 100-8310 (JP)
(74) Representative: Pfenning, Meinig & Partner GbR
(86) International application number: PCT/JP2010/070002
(87) International publication number: WO 2012/063329

(57) **Abstract**

It is an object to attain both high gain and a broad band (that is, to attain both reduction in a gate-drain capacitance and reduction in a source-drain capacitance). Provided is a semiconductor device, including: a GaN channel layer (3) through which electrons travel; a barrier layer (4) which is provided on the GaN channel layer in order to form two-dimensional electron gas in the GaN channel layer and which contains at least any one of In, Al, and Ga and contains N; a gate electrode (8), a source electrode (6), and a drain electrode (7); and a plate (20) formed of a material having polarization, which is provided between the gate electrode (8) and the drain electrode (7), the plate being held in contact with a part of the barrier layer (4).

## Description

### Technical Field

The present invention relates to a semiconductor device having a structure for enhancing gain and band characteristics of an amplifier using a high-electron mobility transistor device (HEMT) of a nitride semiconductor represented by GaN, and a method of manufacturing the semiconductor device.

### Background Art

A structure of a HEMT using a nitride semiconductor represented by GaN (GaN HEMT) is known (see, for example, Non Patent Literature 1). Taking as an example "GaN-Based RF Power Devices and Amplifiers" presented in Non Patent Literature 1, the structure is described below.

Gain is an important feature of an amplifier. The gain is proportional to the ratio of a mutual conductance (gm) to a gate-drain capacitance (Cgd). Therefore, reduction in Cgd results in gain enhancement.

As a method for reducing Cgd, Fig. 5(b) of Non Patent Literature 1 presents a method using a source field plate (SFP). This is a method in which an electrode having the same potential as that of a source is placed between a gate and a drain. According to this conventional method, a part of electric flux lines between the gate and the drain extends toward the field plate, and thus, the electric flux lines between the gate and the drain decrease to reduce Cgd.

### Citation List

### Non Patent Literature

[NPL 1] "GaN-Based RF Power Devices and Amplifiers", Proceedings of the IEEE, Vol. 96, No. 2, p. 287 (2008)

### Summary of Invention

### Technical Problem

However, the conventional technology has the following problem.
According to this conventional method, the electric flux lines between the gate and the drain are reduced, but electric flux lines between the field plate and the drain are increased. In this case, the potential of the field plate is the same as that of the source, and thus, the result is that the source-drain capacitance (Cds) is increased.

Increase in Cds limits the band of the amplifier. Further, when the SFP is not used, although Cds is not increased, Cgd cannot be reduced. From the above-mentioned reason, in a conventional semiconductor device using a GaN HEMT, it is difficult to attain both high gain and a broad band (that is, to attain both reduction in Cgd and reduction in Cds).

In a microwave amplifier, signals in a wide frequency band are required to be amplified with high gain. However, in a conventional semiconductor device using a GaN HEMT, reduction in Cgd for the purpose of enhancing the gain results in increase in Cds, and it is difficult to attain both gain and band.

The present invention has been made to solve the above-mentioned problem, and an object of the present invention is to obtain a semiconductor device using a GaN HEMT which can attain both high gain and a broad band (that is, attain both reduction in gate-drain capacitance and reduction in source-drain capacitance), and a method of manufacturing the semiconductor device.

### Solution to Problem

According to the present invention, there is provided a semiconductor device, including: a GaN channel layer through which electrons travel; a barrier layer which is provided on the GaN channel layer in order to form two-dimensional electron gas in the GaN channel layer and which contains at least any one of In, Al, and Ga and contains N; a gate electrode, a source electrode, and a drain electrode; and a plate formed of a material having polarization, which is provided between the gate electrode and the drain electrode, the plate being held in contact with a part of the barrier layer and held out of contact with the gate electrode.

According to the present invention, there is provided a method of manufacturing a semiconductor device, the semiconductor device including: a GaN channel layer through which electrons run; a barrier layer which is provided on the GaN channel layer in order to form two-dimensional electron gas in the GaN channel layer and which contains at least any one of In, Al, and Ga and contains N; a gate electrode, a source electrode, and a drain electrode; and a plate formed of a material having polarization, which is provided between the gate electrode and the drain electrode, the plate being held in contact with a part of the barrier layer, the method including: a step of manufacturing the barrier layer; and thereafter a step of manufacturing the plate in the same manufacturing system used in manufacturing the barrier layer without exposing the plate to atmosphere.

### Advantageous Effects of Invention

According to the semiconductor device and the method of manufacturing the semiconductor device of the present invention, by further including the plate formed of the material having polarization, which is provided between the gate electrode and the drain electrode so as to be held in contact with a part of the barrier layer, there can be obtained a semiconductor device using a GaN HEMT which can attain both high gain and a broad band (that is, attain both reduction in Cgd and reduction in Cds) and a method of manufacturing the semiconductor device.

### Brief Description of Drawings

[FIG. 1] A sectional view of a conventional semiconductor device using a GaN HEMT without a source field plate.
[FIG. 2] A potential distribution map in the conventional semiconductor device using a GaN HEMT illustrated in FIG. 1.
[FIG. 3] A sectional view of a semiconductor device using a GaN HEMT according to a first embodiment of the present invention.
[FIG. 4] A potential distribution map in the semiconductor device using a GaN HEMT according to the first embodiment of the present invention illustrated in FIG 3.
[FIG. 5] An explanatory view illustrating definitions of dimensions of a GaN plate in the semiconductor device according to the first embodiment of the present invention.
[FIG. 6] A graph showing the relationship between Cgd and distance in the semiconductor device according to the first embodiment of the present invention.
[FIG. 7] A graph showing the relationship between Cds and distance in the semiconductor device according to the first embodiment of the present invention.
[FIG. 8] A graph showing the relationship between Cgd and length in the semiconductor device according to the first embodiment of the present invention.
[FIG. 9] A graph showing the relationship between Cds and distance in the semiconductor device according to the first embodiment of the present invention.
[FIG. 10] A graph showing the relationship between Cgd and thickness in the semiconductor device according to the first embodiment of the present invention.
[FIG. 11] A graph showing the relationship between Cds and thickness in the semiconductor device according to the first embodiment of the present invention.
[FIG. 12] A sectional view of a semiconductor device using a GaN HEMT according to a second embodiment of the present invention.
[FIG. 13] A sectional view of a semiconductor device using a GaN HEMT according to a third embodiment of the present invention.
[FIG. 14] A plan view of the semiconductor device using a GaN HEMT according to the third embodiment of the present invention.
[FIG. 15] An explanatory view illustrating a method of manufacturing a semiconductor device according to a fourth embodiment of the present invention.
[FIG. 16] An explanatory view illustrating the method of manufacturing a semiconductor device according to the fourth embodiment of the present invention.
[FIG. 17] An explanatory view illustrating the method of manufacturing a semiconductor device according to the fourth embodiment of the present invention.
[FIG. 18] An explanatory view illustrating the method of manufacturing a semiconductor device according to the fourth embodiment of the present invention.
[FIG. 19] An explanatory view illustrating the method of manufacturing a semiconductor device according to the fourth embodiment of the present invention.

### Description of Embodiments

A semiconductor device and a method of manufacturing the semiconductor device according to exemplary embodiments of the present invention are described in the following with reference to the drawings.

### First Embodiment

It is known that gain G can be improved by reducing Cgd and a frequency band W can be improved by reducing Cds. The magnitude of a capacitance (such as Cgd or Cds) is known from distribution of a potential formed in a GaN HEMT. For example, in the case of Cgd, a capacitance is thought to be generated in a region in which equipotential lines are dense in potential distribution between a gate and a drain.

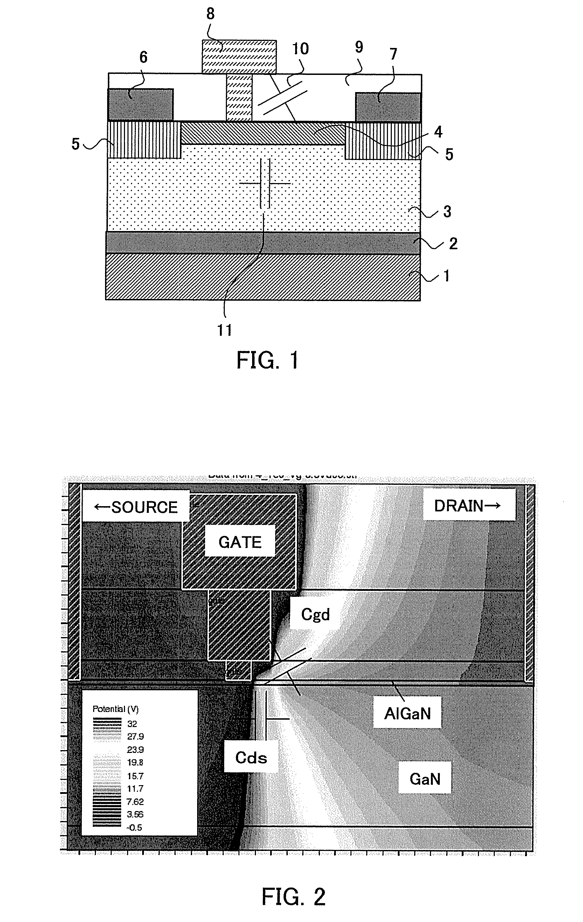

Accordingly, potential distribution on a cross-section of a GaN HEMT was calculated by device simulation. FIG. 1 is a sectional view of a conventional semiconductor device using a GaN HEMT without a source field plate. The conventional semiconductor device illustrated in FIG. 1 includes a substrate 1, a buffer 2, a GaN channel 3, an AlGaN barrier 4, n-type heavily doped impurity (n+) regions 5, a source electrode 6, a drain electrode 7, a gate electrode 8, and a protective film 9.

The semiconductor device actually also includes an element isolation region, wiring, and the like, which are omitted from FIG. 1. Further, in FIG. 1, a gate-drain capacitance 10 (equivalent to Cgd) and a source-drain capacitance 11 (equivalent to Cds) are schematically illustrated.

Further, FIG. 2 is a potential distribution map in the conventional semiconductor device using a GaN HEMT illustrated in FIG. 1. As illustrated in FIG. 2, the potential distribution is dense at the side of the gate electrode on the drain side. Two-dimensional electron gas formed under AlGaN on the drain side is substantially at the same level as a drain potential, and thus, the dense portion at the side of the gate electrode corresponds to Cgd. Further, there is also a dense portion under the gate electrode. Two-dimensional electron gas on the source side is substantially at the same level as a source potential, and thus, the region is thought to correspond to Cds.

Accordingly, it is thought that, by causing the potential distribution in these two dense regions to be sparse, Cgd and Cds can be reduced at the same time. A potential varies depending on charges, and thus, by placing a fixed charge around a border region between Cgd and Cds, the potential distribution can be sparse. Therefore, in the present invention, as this fixed charge, polarization of a nitride semiconductor such as GaN or AlGaN, or a pyroelectric material such as a PbTiO3-based material or a PZT-based material is used.

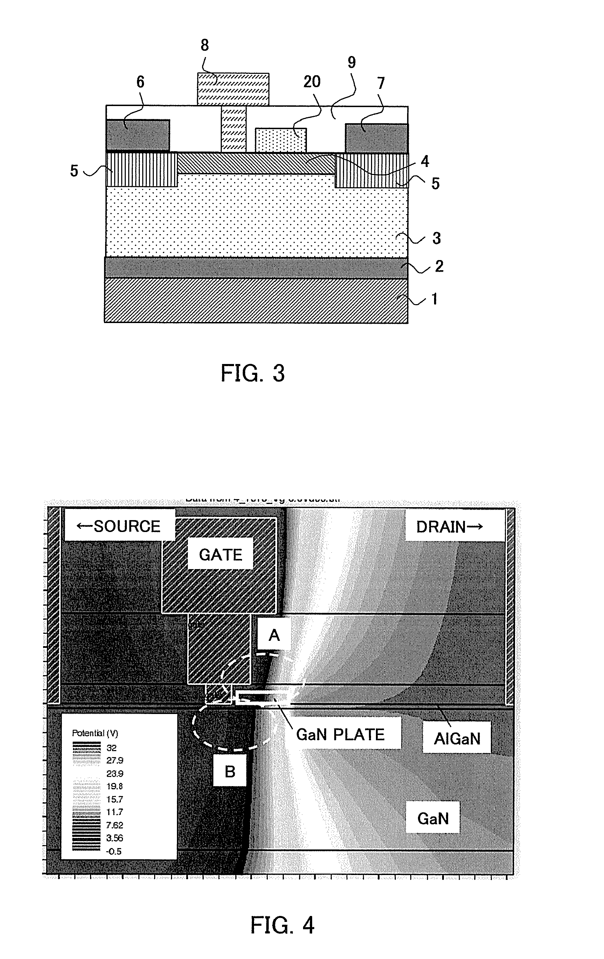

FIG. 3 is a sectional view of a semiconductor device using a GaN HEMT according to a first embodiment of the present invention. The semiconductor device according to the first embodiment illustrated in FIG. 3 includes a substrate 1, a buffer 2, a GaN channel 3, an AlGaN barrier 4, n-type heavily doped impurity (n+) regions 5, a source electrode 6, a drain electrode 7, a gate electrode 8, a protective film 9, and a GaN plate 20. The semiconductor device actually also includes an element isolation region, wiring, and the like, which are irrelevant to the operation of the present invention and are therefore omitted from FIG. 3.

The semiconductor device according to the first embodiment illustrated in FIG. 3 is different from the above-mentioned conventional semiconductor device illustrated in FIG. 1 in further including the GaN plate 20. Further, the semiconductor device according to the present invention can be used as a standalone amplifier, but can also be used as a transistor forming an MMIC.

The substrate 1 is a sapphire substrate, an SiC substrate, an Si substrate, a GaN substrate, or the like. In particular, a semi-insulating SiC substrate which is high in heat conductivity is commonly used, but an Si substrate which is extremely common as a semiconductor substrate is often used.

The buffer 2 is a layer interposed between the substrate 1 and the GaN channel 3. Various structures such as AlN, AlGaN, GaN/InGaN, and AlN/AlGaN are used as the buffer 2 for the purpose of improving the crystallinity of the GaN channel 3 and trapping electrons in the GaN channel 3.

The AlGaN barrier 4 is provided on the GaN channel 3. The AlGaN barrier 4 can obtain the effect of the present invention not only when single-layer AlGaN is used but also when a plurality of kinds of AlGaN having different compositions, film thicknesses, or impurity concentrations are used, or when a combination of AlGaN and GaN or AlN is used.

The n+ regions 5 are formed under the source electrode 6 and under the drain electrode 7 respectively for the purpose of reducing the contact resistances of the source and the drain. Note that, the effect of the present invention can be obtained without the n+ regions 5 insofar as an ohmic contact can be formed for each of the source electrode 6 and the drain electrode 7.

Next, operation of the semiconductor device in the first embodiment is described. In the first embodiment, the GaN plate 20 having polarization (fixed charge) is placed on the AlGaN barrier 4 between the gate electrode 8 and the drain electrode 7.

FIG. 4 is a potential distribution map in the semiconductor device using a GaN HEMT according to the first embodiment of the present invention illustrated in FIG. 3. It can be seen that, compared with the above-mentioned conventional potential distribution illustrated in FIG 2, by further including the GaN plate 20, the potential around the GaN plate 20 becomes sparse.

With regard to potential distribution in regions originating the above-mentioned conventional Cgd and Cds illustrated in FIG. 2, in a region A denoted by a dotted oval in FIG. 4, Cgd can be reduced by the increased distance between equipotential lines. Similarly, in a region B denoted by another dotted oval in FIG. 4, it can be seen that Cds can also be reduced by the increased distance between equipotential lines.

Specifically, it can be seen that, by placing the GaN plate 20 in the above-mentioned region in which the equipotential lines are dense illustrated in FIG. 2, the distance between equipotential lines is increased in that portion to enable reduction of both Cgd and Cds. By placing the GaN plate 20 so as to be held in contact with the AlGaN barrier 4 thereunder, generation of an extra parasitic capacitance can be inhibited.

Further, in a GaN HEMT which operates at a high frequency, a T-shaped gate electrode 8 is used. When a part of the GaN plate 20 is placed under the T-shaped gate electrode 8 as illustrated in FIG. 3, both Cgd and Cds can be reduced more effectively.

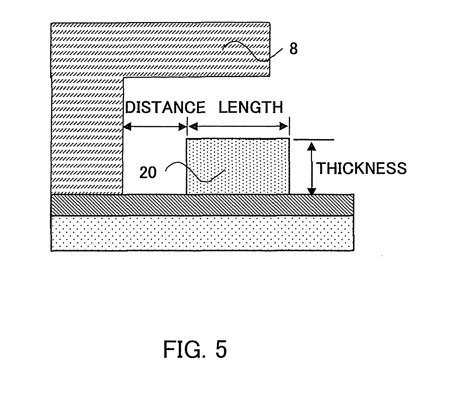

Next, for the purpose of indicating a more specific effect of the GaN plate 20, Cgd and Cds were calculated by device simulation. FIG. 5 is an explanatory view illustrating definitions of dimensions of the GaN plate 20 in the semiconductor device according to the first embodiment of the present invention. The distance, length, and thickness are defined as follows.
distance: space between a base portion of the T-shaped gate electrode 8 and the GaN plate 20
length: horizontal dimension of the GaN plate 20 in FIG. 5
thickness: vertical dimension of the GaN plate 20 in FIG. 5

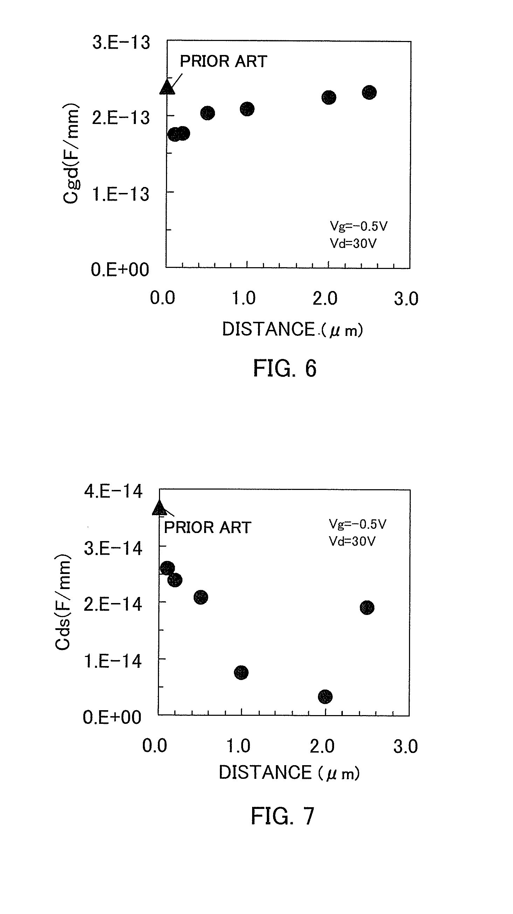

Next, the result of calculation of Cgd and Cds when, among these three parameters (distance, length, and thickness), two parameters are fixed and the remaining one parameter is variable is described with reference to FIG. 6 to FIG 11.

### (1) Result of Calculation of Cgd and Cds when Distance is Variable

FIG. 6 is a graph showing the relationship between Cgd and the distance in the semiconductor device according to the first embodiment of the present invention. Further, FIG. 7 is a graph showing the relationship between Cds and the distance in the semiconductor device according to the first embodiment of the present invention. Note that, the results of calculation shown in FIG. 6 and FIG. 7 are the results when the length is fixed to 0.8 µm, the thickness is fixed to 46 nm, and the distance is variable. Further, for comparison with the conventional art, the results of calculation with regard to a conventional structure without the GaN plate 20 are also shown as a solid triangle.

As is clear from the results of calculation shown in FIG. 6 and FIG. 7, by the provision of the GaN plate 20, both the value of Cgd and the value of Cds obtained are lower than the conventional values. Therefore, by manufacturing an amplifier so as to have a structure including the GaN plate 20, both high gain characteristics and broad band characteristics are expected to be attained.

With reference to the result of calculation shown in FIG. 6, it can be seen that Cgd is increased as the distance from the gate is increased, and approaches the conventional value. Further, with reference to the result of calculation shown in FIG. 7, it can be seen that Cds has a tendency to be reduced around 2 µm. Further, as can be seen from the tendencies shown in FIG. 6 and FIG. 7, Cgd and Cds are in a trade-off. Therefore, an appropriate distance may be adopted depending on the target performance of the amplifier.

With regard to Cgd, judging from the result shown in FIG. 6, when the distance is 3 µm or less, the effect of the present invention that Cgd is reduced can be obtained. Further, taking Cds shown in FIG. 7 into consideration, it can be said that a distance up to 2 µm before the value of Cds is increased is more desirable.

### (2) Result of Calculation of Cgd and Cds when Length is Variable

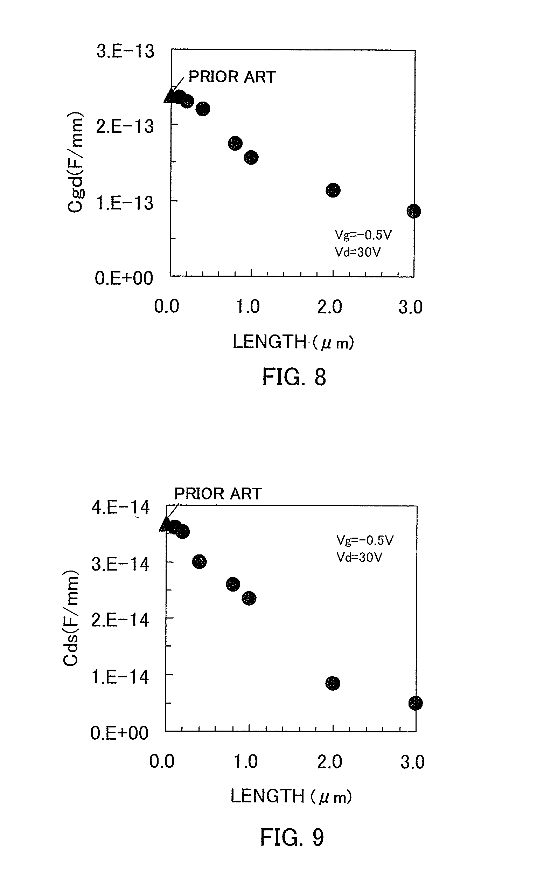

FIG. 8 is a graph showing the relationship between Cgd and the length in the semiconductor device according to the first embodiment of the present invention. Further, FIG. 9 is a graph showing the relationship between Cds and the length in the semiconductor device according to the first embodiment of the present invention. Note that, the results of calculation shown in FIG. 8 and FIG. 9 are the results when the distance is fixed to 0.1 µm, the thickness is fixed to 46 nm, and the length is variable. Further, for comparison with the conventional art, the results of calculation with regard to a conventional structure without the GaN plate 20 are also shown as a solid triangle.

As is clear from the results of calculation shown in FIG. 8 and FIG. 9, by the provision of the GaN plate 20, both the value of Cgd and the value of Cds obtained become further lower than the conventional values as the length becomes larger. However, when the length is 2 µm or more, the rate of reduction decreases. Further, when the length is 0.4 µm or less, the rate of reduction with respect to the conventional value is 10% or less. From this, it is thought that, for the purpose of sufficiently obtaining the effect of the present invention that both Cgd and Cds are reduced, it is appropriate to set the length to be 0.4 to 2 µm.

### (3) Result of Calculation of Cgd and Cds when Thickness is Variable

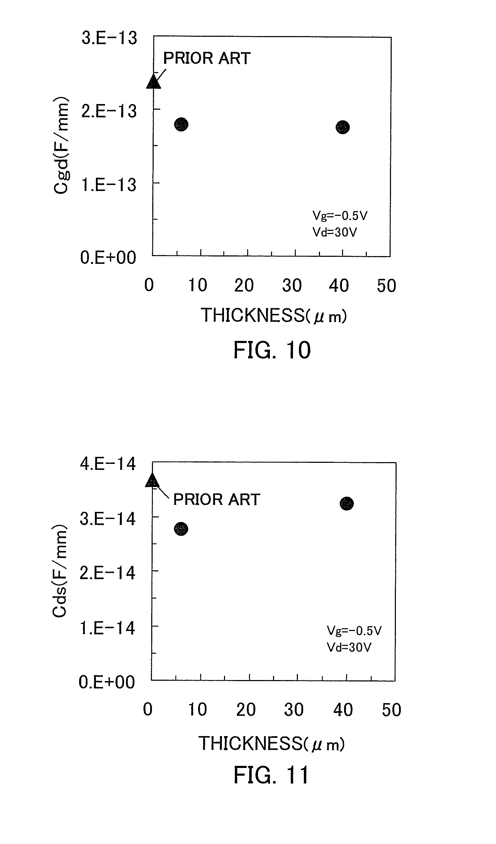

FIG. 10 is a graph showing the relationship between Cgd and the thickness in the semiconductor device according to the first embodiment of the present invention. Further, FIG. 11 is a graph showing the relationship between Cds and the thickness in the semiconductor device according to the first embodiment of the present invention. Note that, the results of calculation shown in FIG. 10 and FIG. 11 are the results when the distance is fixed to 0.1 µm, the length is fixed to 0.8 µm, and the thickness is variable. Further, for comparison with the conventional art, the results of calculation with regard to a conventional structure without the GaN plate 20 are also shown as a solid triangle.

As is clear from the results of calculation shown in FIG 10 and FIG. 11, the sensitivity of the thickness to the provision of the GaN plate 20 has a tendency to be lower than the sensitivity of the distance and the length to the provision of the GaN plate 20. Note that, when the GaN plate 20 is placed under the T-shaped gate electrode 8, it is better that the thickness thereof be small. From FIG. 10 and FIG. 11, it can be seen that the effect can be sufficiently obtained even when the thickness is 40 nm or less.

As described above, according to the first embodiment, there is formed a semiconductor device further including a plate formed of a material having polarization, which is provided between the gate electrode and the drain electrode so as to be held in contact with a part of the barrier layer. As a result, a semiconductor device using a GaN HEMT which can attain both high gain and a broad band (that is, attain both reduction in Cgd and reduction in Cds) can be obtained.

Note that, in the first embodiment, the effect thereof is described taking as an example the GaN plate 20 manufactured from GaN. However, the present invention is not limited to the GaN plate 20. For the purpose of changing the potential, GaN is not necessarily required to be used, and the material which has a fixed charge, that is, polarization may be used. Therefore, a similar effect can be obtained even when a nitride semiconductor other than GaN, for example, AlGaN, InGaN, AlN, InN, or AlInGaN, is used.

Further, the plate may be formed of a pyroelectric material (a PbTiO3-based material such as PbCaTiO3 or PbTiO3-La2/3TiO3, or a PZT-based material such as Pb(Ti,Zr)O3-Pb(Sn1/2Sb1/2)O3). Further, the plate may be crystalline, polycrystalline, or amorphous. Further, even when a plate in which a plurality of such various kinds of plates are combined is used, a similar effect can be obtained.

Further, the impurity concentration in the GaN plate 20 is uniform in the first embodiment, but the impurity concentration in the GaN plate may be nonuniform. Further, the GaN plate 20 in the first embodiment is not held in contact with the gate electrode 8. Therefore, the GaN plate 20 can be applied also to a gate recess in which etching is carried out under the gate electrode 8.

### Second Embodiment

In the above-mentioned first embodiment, a case in which there is one GaN plate 20 is described. On the other hand, in this second embodiment, a case in which a plurality of GaN plates 20 are used is described.

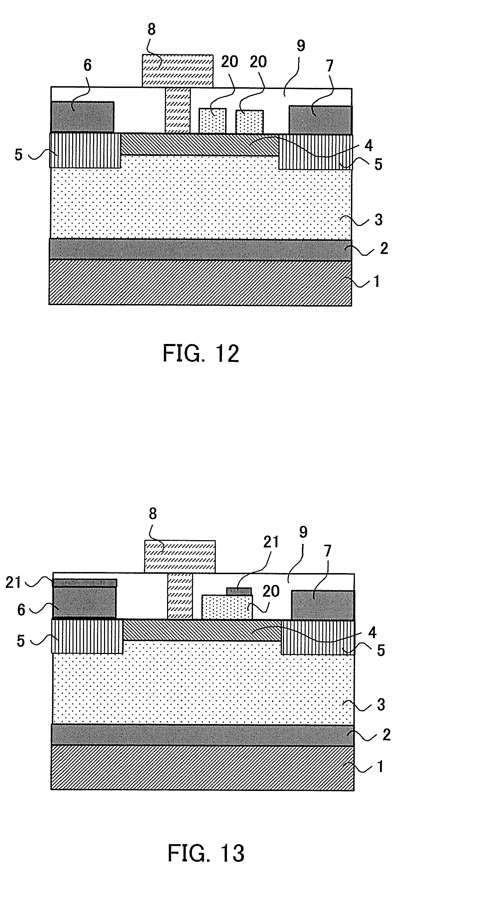

FIG. 12 is a sectional view of a semiconductor device using a GaN HEMT according to the second embodiment of the present invention. The semiconductor device according to the second embodiment illustrated in FIG. 12 includes the substrate 1, the buffer 2, the GaN channel 3, the AlGaN barrier 4, the n-type heavily doped impurity (n+) regions 5, the source electrode 6, the drain electrode 7, the gate electrode 8, the protective film 9, and the plurality of GaN plates 20.

The semiconductor device according to the second embodiment illustrated in FIG. 12 is different from the above-mentioned semiconductor device according to the first embodiment illustrated in FIG. 3 in that the GaN plate 20 is divided into two portions and provided. An effect similar to that of the above-mentioned first embodiment can be obtained also in a case in which the GaN plate 20 is divided into two or more portions in this way.

As described above, according to the second embodiment, there is formed a semiconductor device further including a plurality of plates formed of a material having polarization, which are provided between the gate electrode and the drain electrode so as to be held in contact with a part of the barrier layer. As a result, similarly to the case of the above-mentioned first embodiment, a semiconductor device using a GaN HEMT which can attain both high gain and a broad band (that is, attain both reduction in Cgd and reduction in Cds) can be obtained.

### Third Embodiment

In the above-mentioned first and second embodiments, cases in which the potential of the GaN plate 20 is not fixed are described. On the other hand, in this third embodiment, a case in which the potential of the GaN plate 20 is fixed is described.

For example, the GaN plate 20 may be connected by wiring to the source electrode 6 to be at the source potential. FIG. 13 is a sectional view of a semiconductor device using a GaN HEMT according to the third embodiment of the present invention. The semiconductor device according to the third embodiment illustrated in FIG. 13 includes the substrate 1, the buffer 2, the GaN channel 3, the AlGaN barrier 4, the n-type heavily doped impurity (n+) regions 5, the source electrode 6, the drain electrode 7, the gate electrode 8, the protective film 9, the GaN plate 20, and wiring 21.

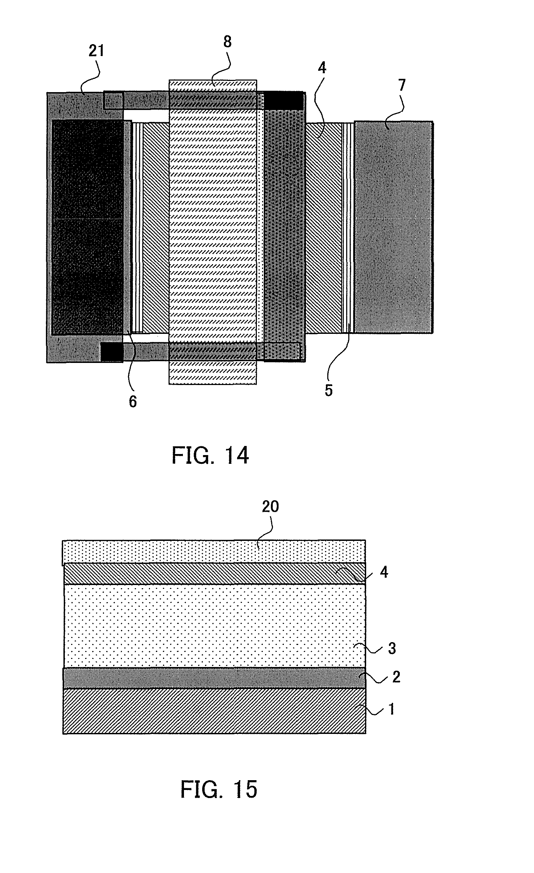

Further, FIG. 14 is a plan view of the semiconductor device using a GaN HEMT according to the third embodiment of the present invention. In particular, as illustrated in the plan view of FIG. 14, by forming the wiring 21 from the source electrode 6 around an active region, an extra capacitance formed by the gate electrode 8 and the source electrode 6 can be reduced.

As described above, according to the third embodiment, in addition to the structure of the above-mentioned first and second embodiments, a wiring structure for fixing the potential of the plate is further included. As a result, similarly to the cases of the above-mentioned first and second embodiments, a semiconductor device using a GaN HEMT which can attain both high gain and a broad band (that is, attain both reduction in Cgd and reduction in Cds) can be obtained. Further, by connecting the plate and the source electrode by wiring, for example, a further effect can be obtained that an extra capacitance formed by the gate electrode and the source electrode can be reduced.

### Fourth Embodiment

In the above-mentioned first to third embodiments, the structure and operation of the semiconductor device according to the present invention are described, and the effectiveness thereof is demonstrated from the results of calculation by device simulation. On the other hand, in this fourth embodiment, a method of manufacturing a semiconductor device according to the present invention is described.

FIG. 15 to FIG. 19 are explanatory views illustrating the method of manufacturing a semiconductor device according to the fourth embodiment of the present invention. Note that, in the fourth embodiment, a manufacturing method for obtaining the structure of the above-mentioned first embodiment illustrated in FIG. 3 is specifically described with reference to FIG. 15 to FIG. 19.

First, as illustrated in FIG. 15, the buffer 2, the GaN channel 3, the AlGaN barrier 4, and further, the GaN plate 20 are sequentially formed on the substrate 1 through crystal growth. MOCVD and MBE can be used for the crystal growth.

Further, when the GaN plate 20 is formed by a manufacturing method other than that for other layers (for example, plasma CVD, sputtering, or vapor deposition), the GaN plate 20 may be formed after the structure up to the AlGaN barrier 4 is formed by crystal growth.

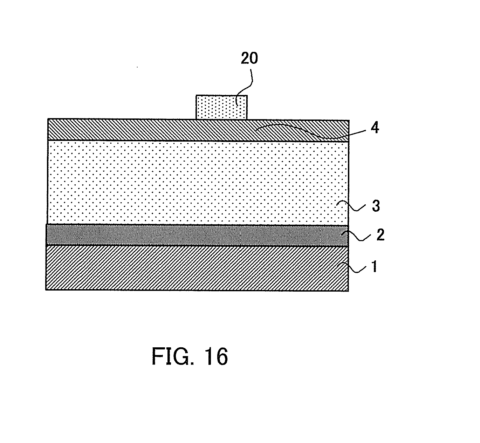

Then, as illustrated in FIG. 16, the GaN plate 20 is removed while a part thereof is left. The removing processing can be realized by using photolithography and plasma or chemical etching. When chemical etching is used, by applying, for example, mixture gas of chlorine gas and Ar gas in a plasma state, etching can be carried out. Further, as an etching mask, a resist, SiO, or SiN can be used.

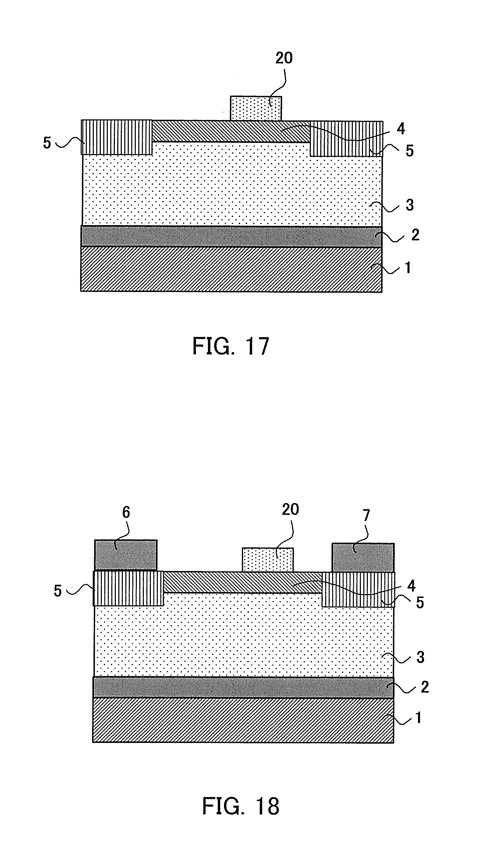

Then, as illustrated in FIG. 17, the n+ regions 5 are selectively formed only under the source electrode 6 and the drain electrode 7, respectively, which are to be formed in the subsequent process. As this forming processing, an ion implantation technology in which Si ions are implanted and are electrically activated by high temperature heat treatment can be used.

Then, as illustrated in FIG. 18, the source electrode 6 and the drain electrode 7 are formed on the n+ regions 5, respectively. By selectively forming the electrodes by photolithography and lift-off and then carrying out heat treatment, satisfactory ohmic electrodes can be formed.

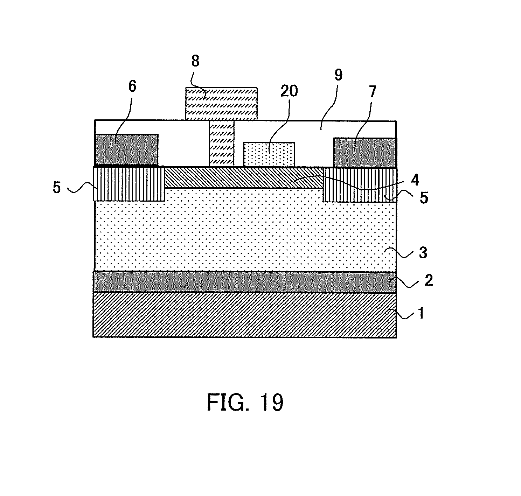

Finally, by forming the gate electrode 8, the protective film 9, the wiring (not shown), and the like as illustrated in FIG. 19, the semiconductor device in the above-mentioned first embodiment illustrated in FIG. 3 can be manufactured.

As described above, according to the fourth embodiment, the plate (GaN plate) which is a technical feature of the present invention can be easily built at a location between the gate electrode and the drain electrode so as to be held in contact with a part of the barrier layer by using an existing manufacturing system.

Note that, in the fourth embodiment, a case in which, after the GaN plate 20 is etched (FIG. 16), the n+ regions 5, the source electrode 6, and the drain electrode 7 are formed (FIG. 17 and FIG. 18) is described. However, the GaN plate 20 may be etched after the n+ regions 5, the source electrode 6, and the drain electrode 7 are formed in advance (FIG. 17 and FIG. 18). Further, the formation of the n+ regions 5 (FIG. 17) may be omitted insofar as sufficient ohmic characteristics can be obtained.

Further, in the case of manufacturing the structure having the wiring 21 described in the above-mentioned third embodiment, after the series of processes illustrated in FIG. 15 to FIG. 19 are carried out, the source electrode 6 and the GaN plate 20 are connected by the wiring 21. In this case, by using photolithography and lift-off, the wiring 21 may be manufactured.

## Claims

1. A semiconductor device, comprising:
a GaN channel layer through which electrons travel;
a barrier layer which is provided on the GaN channel layer in order to form two-dimensional electron gas in the GaN channel layer and which contains at least any one of In, Al, and Ga and contains N;
a gate electrode, a source electrode, and a drain electrode; and
a plate formed of a material having polarization, which is provided between the gate electrode and the drain electrode, the plate being held in contact with a part of the barrier layer.

2. A semiconductor device according to claim 1, wherein:
the gate electrode has a T-shaped structure in which a length of a portion thereof held in contact with the barrier layer is smaller than a length of an upper portion thereof; and
a part of the plate is placed under the upper portion of the gate electrode.

3. A semiconductor device according to claim 1, wherein the plate is connected to the source electrode by wiring.

4. A semiconductor device according to claim 1, wherein the plate is divided into two or more portions and provided.

5. A semiconductor device according to claim 1, wherein the plate is formed of a material which is any one or more of a nitride semiconductor and a PbTiO3-based pyroelectric material or a PZT-based pyroelectric material.

6. A method of manufacturing a semiconductor device,
the semiconductor device comprising:
a GaN channel layer through which electrons travel;
a barrier layer which is provided on the GaN channel layer in order to form two-dimensional electron gas in the GaN channel layer and which contains at least any one of In, Al, and Ga and contains N;
a gate electrode, a source electrode, and a drain electrode; and
a plate formed of a material having polarization, which is provided between the gate electrode and the drain electrode, the plate being held in contact with a part of the barrier layer,
the method comprising:
a step of manufacturing the barrier layer; and
thereafter a step of manufacturing the plate in the same manufacturing system used in manufacturing the barrier layer without exposing the plate to atmosphere.

## Amended claims

### Amended claims under Art. 19.1 PCT

**1.** Amended) A semiconductor device, comprising:
a GaN channel layer through which electrons travel;
a barrier layer which is provided on the GaN channel layer in order to form two-dimensional electron gas in the GaN channel layer and which contains at least any one of In, Al, and Ga and contains N;
a gate electrode, a source electrode, and a drain electrode; and
a plate formed of a material having polarization, which is provided between the gate electrode and the drain electrode, the plate being held in contact with a part of the barrier layer and held out of contact with the gate electrode.

**2.** A semiconductor device according to claim 1, wherein:
the gate electrode has a T-shaped structure in which a length of a portion thereof held in contact with the barrier layer is smaller than a length of an upper portion thereof; and
a part of the plate is placed under the upper portion of the gate electrode.

**3.** A semiconductor device according to claim 1, wherein the plate is connected to the source electrode by wiring.

**4.** A semiconductor device according to claim 1, wherein the plate is divided into two or more portions and provided.

**5.** A semiconductor device according to claim 1, wherein the plate is formed of a material which is any one or more of a nitride semiconductor and a PbTiO3-based pyroelectric material or a PZT-based pyroelectric material.

**6.** Amended) A method of manufacturing a semiconductor device,
the semiconductor device comprising:
a GaN channel layer through which electrons travel;
a barrier layer which is provided on the GaN channel layer in order to form two-dimensional electron gas in the GaN channel layer and which contains at least any one of In, Al, and Ga and contains N;
a gate electrode, a source electrode, and a drain electrode; and
a plate formed of a material having polarization, which is provided between the gate electrode and the drain electrode, the plate being held in contact with a part of the barrier layer and held out of contact with the gate electrode,
the method comprising:
a step of manufacturing the barrier layer; and
thereafter a step of manufacturing the plate in the same manufacturing system used in manufacturing the barrier layer without exposing the plate to atmosphere.
